# EUROPEAN PATENT APPLICATION

(11) **EP 4 739 005 A1**
(43) Date of publication of application: **06.05.2026**
(21) Application number: 25205311.1
(22) Date of filing: 29.09.2025
(51) Int. Cl.: H05K 1/02, H05K 3/28

(54) **SENSING DEVICE**

(30) Priority: 30.10.2024 IN 202411083186; 14.08.2025 US 202519300239
(71) Applicant: Honeywell International Inc., Charlotte, NC 28202 (US)
(72) Inventor: HEGDE, Santosh Nagapati, Charlotte, 28202 (US); JAIN, Rajani Niranjan, Charlotte, 28202 (US); S, Vijayakumar, Charlotte, 28202 (US); HM, Manjunatha, Charlotte, 28202 (US); MORAN, Michael, Charlotte, 28202 (US); MAUT, Sandeep Laxman, Charlotte, 28202 (US); HINTZ, Fred, Charlotte, 28202 (US); FURLONG, Gregory, Charlotte, 28202 (US); SORENSO, Richard, Charlotte, 28202 (US)
(74) Representative: Haseltine Lake Kempner LLP

(57) **Abstract**

A sensing device is disclosed. The sensing device comprising a printed circuit board (PCB), a conductive port coupled to the PCB via a conductive adhesive and defining an orifice filled with a protective gel. Further, the sensing device comprises a sensing element disposed on the PCB within the conductive port and encased by the protective gel, and a conductive member disposed at least over the protective gel. The conductive member is configured to discharge static charges accumulated over the protective gel to the PCB via at least the conductive adhesive.

## Description

### CROSS-REFERENCE TO RELATED APPLICATIONS

This application claims priority to and the benefit of Indian Application No. 202411083186, filed October 30, 2024, which is incorporated herein by reference in its entirety.

### TECHNOLOGICAL FIELD

Example embodiments of the present disclosure relate generally to a sensing device, and more particularly, to a sensing device and a method thereof for discharging static charges.

### BACKGROUND

In various industrial applications, sensors are essential devices that detect and respond to various physical, chemical, or environmental changes, converting these changes into measurable signals. The sensors are widely used in applications ranging from industrial automation and healthcare to consumer electronics and environmental monitoring. Despite their versatility, sensors can be vulnerable to electrostatic discharge (ESD), a sudden flow of electricity between two charged objects caused by contact, movement, or an electrical short circuit. ESD often causes sensors to malfunction, leading to inaccurate readings or delayed responses. Additionally, gel-coupled sensors have viscous material that carries a static charge. The static charges in both the media and coupling materials can adversely affect the performance of these sensors and thus make them less reliable in certain applications.

The inventors identified numerous deficiencies and problems in existing technologies and processes, which are the subjects of embodiments described herein. Through applied effort, ingenuity, and innovation, many of these deficiencies and problems have been solved by developing solutions that are included in embodiments of the present disclosure, many examples of which are described in detail herein.

### BRIEF SUMMARY

The following presents a summary of some example embodiments to provide a basic understanding of some aspects of the present disclosure. This summary is not an extensive overview and is intended to neither identify key or critical elements nor delineate the scope of such elements. It will also be appreciated that the scope of the disclosure encompasses many potential embodiments in addition to those here summarized, some of which will be further described in the detailed description that is presented later.

In an example embodiment, a sensing device is disclosed. The sensing device comprises a printed circuit board (PCB), a conductive port coupled to the PCB via a conductive adhesive and defining an orifice. Further, the orifice is filled with a protective gel, a sensing element disposed on the PCB within the conductive port and encased by the protective gel, and a conductive member disposed at least over the protective gel, the conductive member is configured to discharge static charges accumulated over the protective gel to the PCB via at least the conductive adhesive.

In some embodiments, the conductive member comprises at least a conductive gel disposed in the orifice over the protective gel. In some embodiments, the conductive gel corresponds to a nickel-graphite silicone gel.

In some embodiments, the conductive member comprises at least a conductive membrane disposed over the protective gel and either partially or fully encapsulating the conductive port.

In some embodiments, the conductive membrane comprises a conductive polyimide film.

In some embodiments, the conductive polyimide film comprises a carbon-impregnated polyimide film.

In some embodiments, the conductive membrane comprises at least a polyimide film disposed over the protective gel and either partially or fully encapsulating the conductive port. In some embodiments, the polyimide film defines a first side having a non-metallic surface and a second side having a metallic surface, and the non-metallic surface is in contact with the protective gel and the metallic surface is in contact with the conductive port to discharge the static charges from the polyimide film, the conductive port, and the conductive adhesive to the PCB.

In some embodiments, the conductive membrane further comprises at least one conductive polyimide tab inserted within a plated through hole (PTH) defined in the PCB such that the static charges discharge directly from the conductive polyimide film to the PCB.

In some embodiments, the conductive membrane comprises a main body and a tab extending from an edge of the main body. The tab comprise a proximal portion adjacent the edge of the many body and a distal portion extending from and narrower than the proximal portion. The distal portion of the tab is inserted within a plated through hole (PTH) defined in the PCB such that the static charges discharge directly from the conductive membrane to the PCB.

In some embodiments, the protective gel corresponds to at least one of silicone gel. In some embodiments, the conductive port corresponds to at least one of a metal port or a conductive plastic port.

In some embodiments, the conductive member comprises at least a conductive membrane is disposed over the protective gel and encapsulates the conductive port coupled with the PCB such that the static charges directly discharge from the conductive membrane to the PCB.

In another example embodiment, a sensing device is disclosed. The sensing device comprising a printed circuit board (PCB), a port coupled to the PCB via an adhesive and defining an orifice. Further, the orifice is filled with a protective gel, a sensing element disposed on the PCB within the port and encased by the protective gel, and a conductive membrane disposed over the protective gel and the port to fully encapsulate the port. Further, the conductive membrane discharges static charges accumulated over the protective gel to the PCB.

In another example embodiment, a method is disclosed. The method comprising coupling, via a conductive adhesive, a conductive port to a printed circuit board (PCB), the conductive port defines an orifice filled with a protective gel; disposing a sensing element on the PCB within the conductive port and encased by the protective gel; and disposing a conductive member at least over the protective gel, the conductive member is configured to discharge static charges accumulated over the protective gel to the PCB via at least the conductive adhesive.

The above summary is provided merely for purposes of summarizing some exemplary embodiments to provide a basic understanding of some aspects of the disclosure. Accordingly, it will be appreciated that the above-described embodiments are merely examples and should not be construed to narrow the scope or spirit of the disclosure in any way. It will be appreciated that the scope of the disclosure encompasses many potential embodiments in addition to those here summarized, some of which are further explained within the following detailed description and its accompanying drawings.

### BRIEF DESCRIPTION OF THE DRAWINGS

Having thus described certain example embodiments of the present disclosure in general terms, reference will hereinafter be made to the accompanying drawings, which are not necessarily drawn to scale, and wherein:
FIG. 1 illustrates a sectional view of a sensing device in accordance with a first example embodiment of the present disclosure;
FIG. 2 illustrates a sectional view of a sensing device in accordance with a second example embodiment of the present disclosure;
FIG. 3 illustrates a sectional view of a sensing device in accordance with a third example embodiment of the present disclosure;
FIG. 4 illustrates a sectional view of a sensing device in accordance with a fourth example embodiment of the present disclosure;
FIG. 5 illustrates a top view of a printed circuit board (PCB) integrated with the sensing device in accordance with the fourth example embodiment of the present disclosure;
FIG. 6 illustrates an isometric view showing operations of a conductive polyimide film disposed over the sensing device in accordance with the fourth example embodiment of the present disclosure;
FIG. 7 illustrates an isometric view of the conductive polyimide film in accordance with the fourth example embodiment of the present disclosure;
FIG. 8 illustrates an exploded view of the conductive polyimide film in accordance with the fourth example embodiment of the present disclosure;
FIG. 9 illustrates a table having data associated with the conductive polyimide film in accordance with an example embodiment of the present disclosure;
FIG. 10 illustrates a top view of an example conductive membrane that may be disposed over the sensing device in accordance with example embodiments of the present disclosure;
FIG. 11 illustrates an isometric view of a portion of the conductive membrane of FIG. 10 in use; and
FIG. 12 illustrates a sectional view of a portion of the conductive membrane of FIG. 10 in use.

### DETAILED DESCRIPTION

Some embodiments will now be described more fully hereinafter with reference to the accompanying drawings, in which some, but not all, embodiments of the present disclosure are shown. Indeed, various embodiments may be embodied in many different forms and should not be construed as limited to the embodiments set forth herein; rather, these embodiments are provided so that this disclosure will satisfy applicable legal requirements.

The components illustrated in the figures represent components that may or may not be present in various embodiments of the present disclosure described herein such that embodiments may include fewer or more components than those shown in the figures while not departing from the scope of the present disclosure. Some components may be omitted from one or more figures or shown in dashed line for visibility of the underlying components.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

The present disclosure provides various embodiments of a sensing device. Embodiments of the present disclosure may comprise a printed circuit board (PCB). Embodiments of the present disclosure may comprise a conductive port that may be coupled to the PCB via a conductive adhesive and may define an orifice. The orifice may be filled with a protective gel. Embodiments of the present disclosure may comprise a sensing element that may be disposed on the PCB within the conductive port and may be encased by the protective gel. Embodiments of the present disclosure may comprise a conductive member that may be disposed at least over the protective gel. The conductive member may be configured to discharge static charges accumulated over the protective gel to the PCB via at least the conductive adhesive.

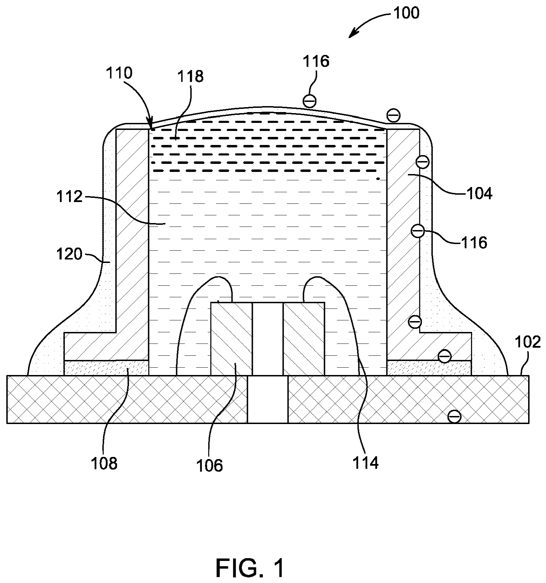

FIG. 1 illustrates a sectional view of a sensing device 100, in accordance with a first example embodiment of the present disclosure.

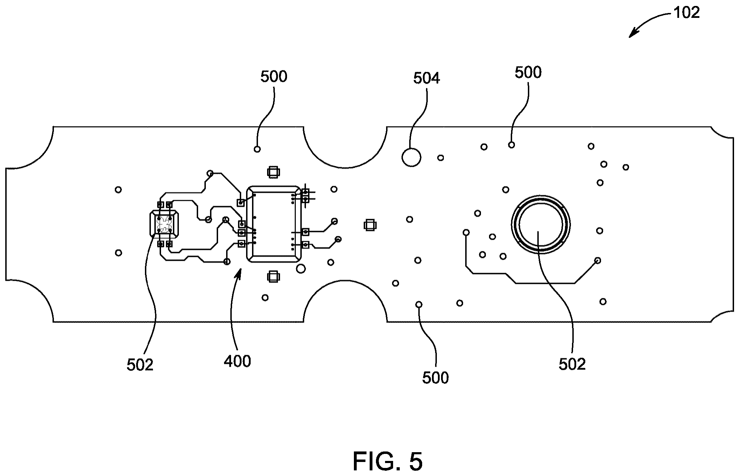

In some embodiments, the sensing device 100 may comprise a printed circuit board (PCB) 102, a conductive port 104, and a sensing element 106. In some embodiments, the sensing device 100 may be installed within an industrial setting (not shown). Further, the industrial setting may include environment such as manufacturing plants, chemical processing facilities, oil refineries, or power plants. Further, the environment may involve various complex systems. The system may comprise at least one of a pipeline network, a conveyor system, or any other mechanical or automated system requiring continuous monitoring. In some embodiments, the sensing device 100 may be configured to measure one or more quantities associated with the industrial setting to ensure operational efficiency, safety, and reliability. In some embodiments, the one or more quantities may include, but are not limited to, pressure, force, volume, motion, distance, temperature, humidity etc. In some embodiments, the sensing device 100 may be configured to generate one or more signals associated with the one or more quantities. In some embodiments, the one or more signals may comprise at least one of analog signals or digital signals. In various examples, the sensing device 100 may be integrated within at least one circuitry. Further, the at least one circuitry may comprise one or more electronic components 502 (FIG. 5) such as resistors, capacitors, inductors, diodes, and transistors.

In some embodiments, the sensing device 100 may comprise the PCB 102. In some embodiments, the PCB 102 may be configured to serve as a foundational structure for electrical connectivity of the sensing device 100. Further, the PCB 102 of the sensing device 100 may be configured to provide necessary electrical connections to various components associated with the sensing device 100. In some embodiments, the PCB 102 may be constructed with a shape that corresponds to a planar shape. Further, the planar shape may provide flexibility for installation in various applications such as handheld devices, embedded systems etc. In some embodiments, the PCB 102 may be constructed with various materials. The materials may include, but are not limited to, fiberglass-reinforced epoxy resin or other similar insulating materials. The material for the PCB 102 may be selected to make the PCB 102 durable, heat resistant, and have insulating properties, ensuring the PCB 102 can withstand various environmental conditions such as vibration, humidity, and temperature fluctuations.

In some embodiments, the sensing device 100 may comprise the conductive port 104. In some embodiments, the conductive port 104 may be coupled to the PCB 102. In some embodiments, the conductive port 104 may be configured to encase one or more components (e.g., the sensing element 106) of the sensing device 100. In some embodiments, the conductive port 104 may be configured to safeguard the sensing element 106 from various potential hazards. In some embodiments, the conductive port 104 of the sensing device 100 may be configured to provide a physical barrier to safeguard the sensing device 100. In some embodiments, the hazards may include, but are not limited to, extreme temperatures, moisture, dust, and debris. Further, the conductive port 104 may protect the one or more components of the sensing device 100 from mechanical stress, impacts, and vibrations that could damage the sensing device 100. In some embodiments, the conductive port 104 of the sensing device 100 may be constructed in various shapes. The shapes may include, but are not limited to, cylindrical shape, conical shape, or hemi-spherical shape. In some embodiments, the conductive port 104 of the sensing device 100 may be constructed with various materials. The materials may include, but are not limited to, aluminum, steel, copper, plastic, etc. In some embodiments, the material of the conductive port 104 may be selected such that a conducting path is created between the conductive port 104 and the PCB 102.

In some embodiments, the conductive port 104 of the sensing device 100 may correspond to at least one of a metal port or a conductive plastic port. In one instance, when the conductive port 104 of the sensing device 100 corresponds to the metal port, then the conductive port 104 may serve as an efficient conductor for electrical signals. Further, the conductive port 104 (i.e., metal port) of the sensing device 100 may be constructed with various materials such as aluminum, steel, copper, or other conductive metals. Further, the material of the conductive port 104 (i.e., metal port) may ensure durability of the conductive port 104. In another instance, when the conductive port 104 of the sensing device 100 corresponds to the conductive plastic port, then the conductive port 104 may serve as an efficient conductor for electrical signals and provide a lightweight and more flexible structure. Further, the conductive port 104 (i.e., conductive plastic port) of the sensing device 100 may be constructed with various materials such as plastic, polycarbonate, or reinforced fiber.

In some embodiments, the conductive port 104 of the sensing device 100 may be coupled to the PCB 102 through a conductive adhesive 108. Further, the conductive adhesive 108 may be configured to affix the conductive port 104 over the PCB 102. In some embodiments, the conductive adhesive 108 may correspond to silver-filled adhesive, graphene-based adhesive, carbon-filled adhesive, nickel-filled adhesive, etc. In some embodiments, the conductive adhesive 108 may be configured to create a mechanical bond between the conductive port 104 with the PCB 102, while creating the conducting path between the conductive port 104 and the PCB 102. In some embodiments, the conductive adhesive 108 may be configured to secure the conductive port 104 with the PCB 102.

In some embodiments, the conductive port 104 of the sensing device 100 may define an orifice 110. Further, the orifice 110 of the conductive port 104 may be configured to accommodate the one or more components of the sensing device 100 (e.g., the sensing element 106). In some embodiments, the orifice 110 of the conductive port 104 may be constructed with various shapes. The shapes may include, but are not limited to, a cylindrical shape, a hemispherical shape, an oval shape, etc. In some embodiments, the orifice 110 of the conductive port 104 may comprise inner walls. Further, the inner walls of the orifice 110 of the conductive port 104 may be constructed with various materials. Further, the material of the inner walls may comprise a metal or a high-grade alloy. Further, the materials of the inner walls may be selected to ensure mechanical strength and efficient conductivity of the orifice 110.

In some embodiments, the sensing device 100 may further comprise the sensing element 106. In some embodiments, the sensing element 106 of the sensing device 100 may be disposed on the PCB 102 within the conductive port 104. In some embodiments, the sensing element 106 may be positioned within the orifice 110 of the conductive port 104. In some embodiments, the sensing element 106 of the sensing device 100 may be configured to determine changes in the one or more physical quantities associated with the industrial setting. In some embodiments, the sensing element 106 may be configured to convert the one or more physical quantities into one or more electrical signals. In some embodiments, the sensing element 106 of the sensing device 100 may be mounted on the PCB 102. In various examples, the sensing element 106 may be mounted on the PCB 102 through a wire-bonding technique. The wire-bonding technique involves an electrical coupling of the sensing element 106 with the PCB 102 through a plurality of conducting wires 114. Further, the plurality of conducting wires 114 may be configured to carry the one or more electrical signals generated by the sensing element 106 to the PCB 102. In some embodiments, the sensing element 106 of the sensing device 100 may be configured to determine the one or more physical quantities (i.e., temperature, pressure, humidity, vibration, force or load, and chemical presence) and generate the one or more electrical signals.

In some embodiments, the sensing element 106 of the sensing device 100 may correspond to a thermocouple or resistance temperature detector (RTD), a piezoelectric element, a capacitive element or resistive element, or optical element. In one instance, when the sensing element 106 corresponds to the thermocouple or RTD, then the sensing element 106 may generate a voltage corresponding to a change in temperature of a target media. In another instance, when the sensing element 106 corresponds to the thermocouple or RTD, then the sensing element 106 may generate a voltage corresponding to a change in temperature of a target media. In another instance, when the sensing element 106 corresponds to the piezoelectric element, then the sensing element 106 may generate a voltage in response to a degree of mechanical stress, such as pressure or vibration experienced by the sensing element 106. In another instance, when the sensing element 106 corresponds to the resistive element, then the sensing element 106 may generate a voltage in response to environmental conditions such as temperature, pressure, or humidity. In another instance, when the sensing element 106 corresponds to the optical element, then the sensing element 106 may be configured to generate a voltage in response to changes in light, including intensity, wavelength, or phase to detect changes in the target media.

In some embodiments, the orifice 110 of the conductive port 104 may be filled with a protective gel 112. Further, the protective gel 112 filled within the orifice 110 of the conductive port 104 may correspond to at least one of silicone gel. In some embodiments, the protective gel 112 may be configured to safeguard the one or more components (i.e., the sensing element 106) inside the conductive port 104. In some embodiments, the protective gel 112 may be configured to provide chemical stability and/or high-temperature resistivity to the sensing device 100. In some embodiments, the protective gel 112 of the sensing device 100 may be configured to form a hermetic seal within the orifice 110 of the conductive port 104. Further, the protective gel 112 filled inside the orifice 110 of the conductive port 104 may be configured to safeguard the one or more components inside the conductive port 104. Further, the protective gel 112 may be configured to prevent intrusion of dust, debris, moisture, and other contaminants inside the conductive port 104 of the sensing device 100. In some embodiments, the protective gel 112 may be configured to provide protection to the one or more components inside the conductive port 104 from mechanical shocks or vibrations. In some embodiments, the protective gel 112 of the sensing device 100 may be configured to provide electrical insulation to the one or more components inside the conductive port 104 of the sensing device 100. The protective gel 112 may be configured to prevent short-circuiting between the one or more components. Further, the protective gel 112 may be configured to dissipate heat generated by the sensing device 100 and prevent overheating of the sensing device 100.

In some embodiments, the sensing device 100 that may be installed in the industrial settings may experience accumulation of static charges 116 during operations of the industrial settings. Further, the static charges 116 accumulated over the sensing device 100 may lead to distortion in the one or more signals generated by the sensing element 106. In some embodiments, the sensing device 100 may comprise a conductive member. In some embodiments, the conductive member of the sensing device 100 may be disposed at least over the protective gel 112. In some embodiments, the conductive member may be configured to discharge the static charges 116 accumulated over the protective gel 112 to the PCB 102 via at least the conductive adhesive 108. In some embodiments, the conductive member may comprise a conductive gel 118 and a conductive membrane 120 altogether, as illustrated in FIG. 1. In some embodiments, the conductive gel 118 may be disposed at least over the protective gel 112. Further, the conductive gel 118 disposed within the orifice 110 of the conductive port 104 may be in contact with the inner walls of the orifice 110. Further, the conductive port 104 of the sensing device 100 may be coupled with the PCB 102 via at least the conductive adhesive 108. In some embodiments, the conductive gel 118, the conductive port 104, the conductive adhesive 108, and the PCB 102 may define a conductive path that may be configured to allow discharging of the static charges 116 accumulated over the protective gel 112.

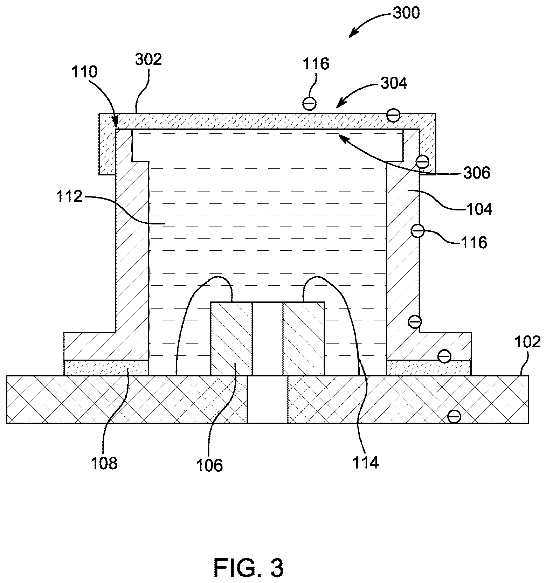

In some embodiments, the conductive membrane 120 may be configured to encapsulate the conductive port 104 and directly coupled with the PCB 102. In some embodiments, the conductive membrane 120 may comprise a conductive silicone membrane. In various examples, the conductive member may comprise the conductive membrane 120 or a conductive polyimide film 302 (FIG. 3) (such as Kapton polyimide film from DuPont) (e.g., the conductive polyimide film 302 may be configured to fully encapsulate the conductive port 104 and directly coupled with the PCB 102). Further, the conductive membrane 120 may be in direct contact with the conductive port 104. In some embodiments, the conductive membrane 120 or the conductive polyimide film 302, the conductive adhesive 108, and the PCB 102 may define a conductive path. Further, the conductive path may facilitate the conductive membrane 120 to fetch the static charges 116 from the surface of the conductive port 104 and discharge the static charges 116 to the PCB 102.

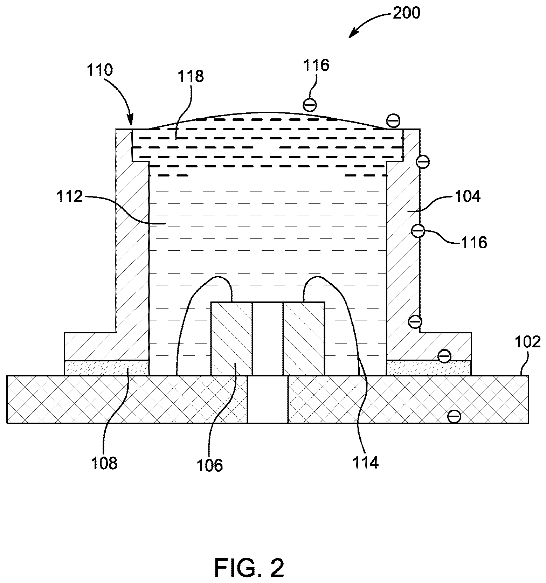

FIG. 2 illustrates a sectional view of a sensing device 200, in accordance with a second example embodiment of the present disclosure.

In some embodiments, the sensing device 200 may comprise the PCB 102, the conductive port 104 coupled to the PCB 102 via the conductive adhesive 108. In some embodiments, the conductive port 104 may define the orifice 110 filled with the protective gel 112. In some embodiments, the sensing device 200 may comprise the conductive gel 118 disposed in the orifice 110 over the protective gel 112. In some embodiments, the conductive gel 118 may correspond to a nickel-graphite silicone gel. The nickel-graphite silicone gel may possess electrical conductivity and flexibility. In some embodiments, the conductive gel 118 may be disposed within the orifice 110 of the conductive port 104 that is filled with the protective gel 112.

In various examples, the conductive gel 118 may comprise a viscosity greater than a viscosity of the protective gel 112 that enables the conductive gel 118 to remain over the protective gel 112 within the orifice 110 of the conductive port 104. In some embodiments, the conductive gel 118 may be in-contact with the inner walls of the orifice 110. In some embodiments, the conductive gel 118 may be configured to work in conjunction with the conductive port 104, conductive adhesive 108, and the PCB 102 to create a conductive path. In some embodiments, the conductive path may be configured to enable movement of the static charges 116 from the protective gel 112 to the conductive gel 118. Further, the conductive port 104 of the sensing device 200 may be configured to drain the static charges 116 to the PCB 102 via the conductive adhesive 108. In some embodiments, the conductive gel 118 may be configured to interface with the conductive port 104 and the protective gel 112 to transfer the static charges 116 accumulated over the protective gel 112 to the PCB 102 via the conductive port 104 and the conductive adhesive 108.

FIG. 3 illustrates a sectional view of a sensing device 300, in accordance with a third example embodiment of the present disclosure.

In some embodiments, the sensing device 300 may comprise the PCB 102 and the conductive port 104 coupled to the PCB 102 via the conductive adhesive 108. In some embodiments, the conductive port 104 may define the orifice 110 filled with the protective gel 112. In some embodiments, the conductive port 104 may be partially or fully encapsulated by the conductive member. Further, the conductive member may comprise at least the conductive polyimide film 302. Further, the conductive polyimide film 302 may be disposed over the protective gel 112. In one instance, the conductive polyimide film 302 may be configured to partially encapsulate the conductive port 104. In another instance, the conductive polyimide film 302 may be configured to fully encapsulate the conductive port 104. In some embodiments, the conductive polyimide film 302 may define a first side 306 and a second side 304.

In some embodiments, the first side 306 of the conductive polyimide film 302 may have a non-metallic surface. In some embodiments, the non-metallic surface of the first side 306 of the conductive polyimide film 302 may be in contact with the protective gel 112. Further, the second side 304 of the conductive polyimide film 302 may have a metallic surface. In some embodiments, the metallic surface of the second side 304 of the conductive polyimide film 302 may be in mechanical contact with the conductive port 104. In some embodiments, the second side 304 of the conductive polyimide film 302, the conductive port 104, the conductive adhesive 108 and the PCB 102 may define a conductive path. In some embodiments, the conductive path may facilitate the conductive polyimide film 302 to capture the static charges 116 from the protective gel 112 and discharge the static charges 116 via the conductive port 104, and the conductive adhesive 108 to the PCB 102. In some embodiments, the non-metallic surface of the conductive polyimide film 302 may be configured to prevent any interference of the static charges 116 with the protective gel 112.

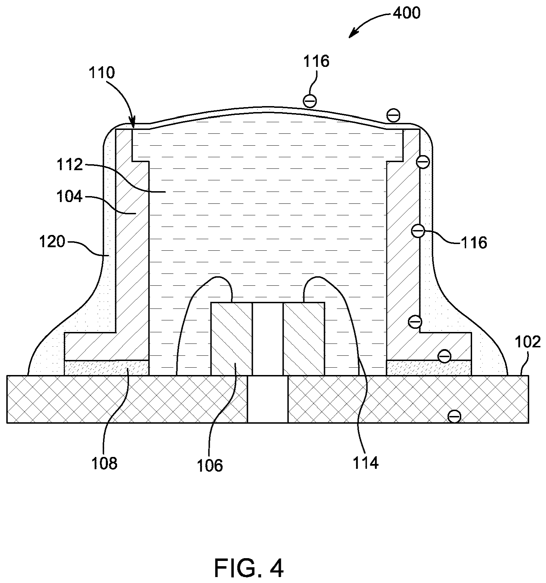

FIG. 4 illustrates a sectional view of a sensing device 400, in accordance with a fourth example embodiment of the present disclosure.

In some embodiments, the sensing device 400 may comprise the PCB 102 and the conductive port 104 coupled to the PCB 102 via the conductive adhesive 108. In some embodiments, the conductive port 104 may define the orifice 110 filled with the protective gel 112. In some embodiments, the sensing device 400 may comprise the conductive member that is configured to fully encapsulate the conductive port 104. Further, the conductive member may comprise the conductive membrane 120. Further, the conductive membrane 120 may be disposed over the protective gel 112 of the sensing device 400. In some embodiments, the conductive membrane 120 of the sensing device 400 may be configured to encapsulate the conductive port 104 coupled to the PCB 102. In some embodiments, the conductive membrane 120 may comprise a conductive silicone membrane. In other embodiments, the conductive member may comprise the conductive polyimide film 302 that is configured to fully encapsulate the conductive port 104.

In some embodiments, the conductive membrane 120 may be configured to create a conductive path between the conductive port 104 and the PCB 102. In some embodiments, the conductive membrane 120 may be in direct contact with the conductive port 104 such that the conductive membrane 120 may be configured to fetch the static charges 116 accumulated over the protective gel 112 and drain the static charges 116 to the PCB 102. In some embodiments, the conductive membrane 120 may be coupled to the PCB 102 such that the static charges 116 may directly discharge from the conductive membrane 120 to the PCB 102. In some embodiments, the conductive membrane 120 may be constructed with a flexible material that may enable the conductive membrane 120 to encapsulate the conductive port 104 of the sensing device 400. In some embodiments, the conductive membrane 120 may be configured to create a pathway that allows the static charges 116 to be transferred from the conductive membrane 120 to the PCB 102.

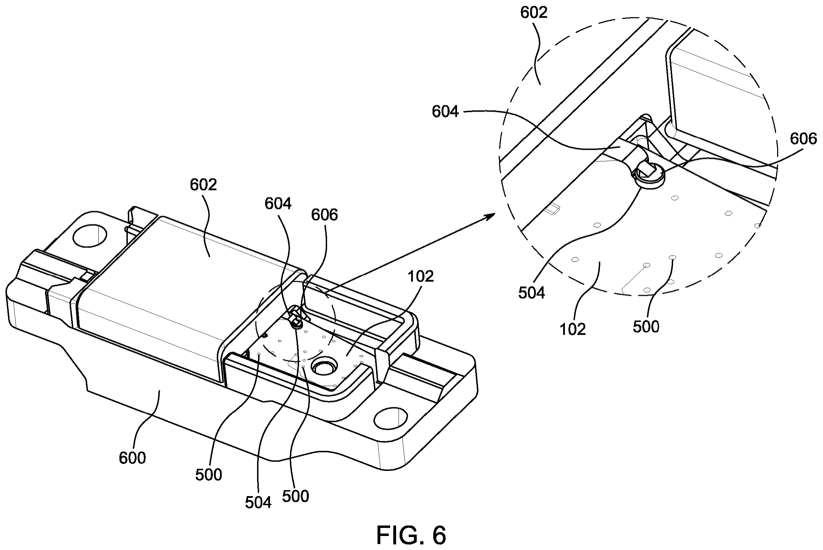

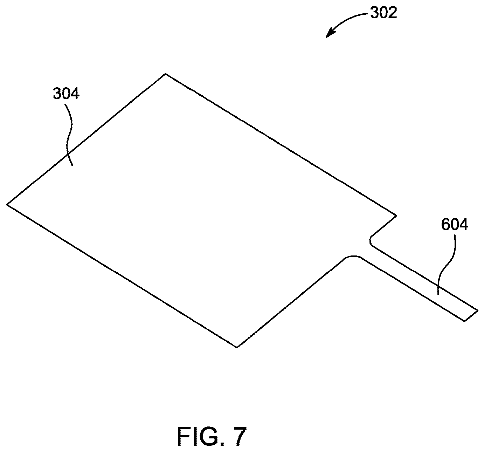

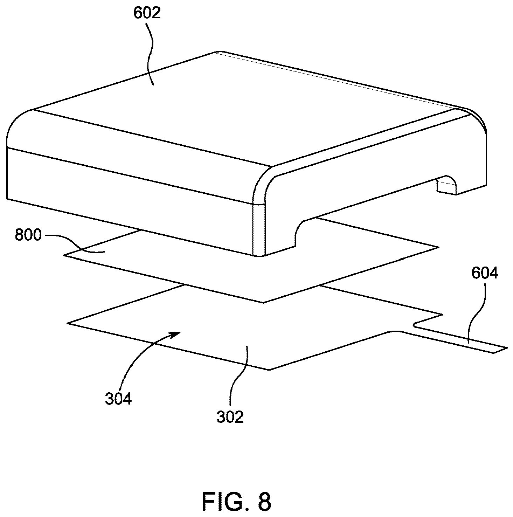

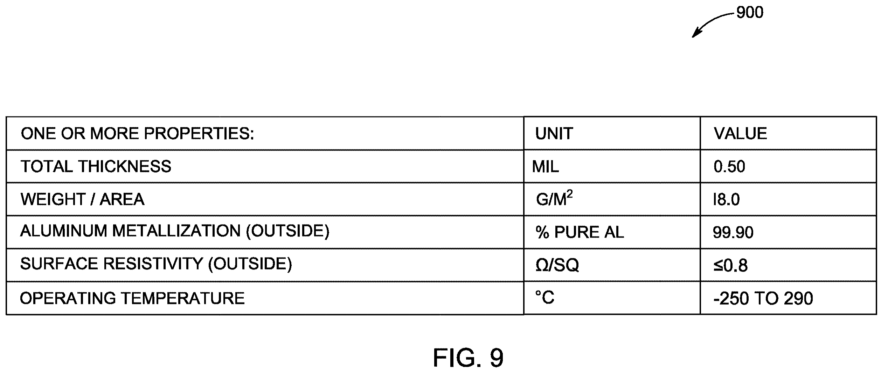

FIG. 5 illustrates a top view of the PCB 102 integrated with the sensing device 400, in accordance with the fourth example embodiment of the present disclosure. FIG. 6 illustrates an isometric view showing operations of the conductive polyimide film 302 disposed over the sensing device 400, in accordance with the fourth example embodiment of the present disclosure. FIG. 7 illustrates an isometric view of the conductive polyimide film 302, in accordance with the fourth example embodiment of the present disclosure. FIG. 8 illustrates an exploded view of the conductive polyimide film 302, in accordance with the fourth example embodiment of the present disclosure. FIG. 9 illustrates a table 900 having data associated with the conductive polyimide film 302, in accordance with an example embodiment of the present disclosure.

In some embodiments, the sensing device 400 may be integrated into various applications, such as an infusion pump (not shown). In some embodiments, the infusion pump may be configured to pump an intravenous (IV) fluid (not shown) from a cartridge (not shown) to a patient's veins through an IV tube (not shown). In some embodiments, the sensing device 400 may be installed within the infusion pump and in contact with the IV tube to measure one or more parameters of the IV fluid. The one or more parameters may include, but are not limited to, a temperature of the IV fluid, a pressure of the IV fluid etc. In some embodiments, when the IV fluid travels within the IV tube from the cartridge to the patient's veins, then the static charges 116 accumulated around walls of the IV tube. In some embodiments, the static charges 116 may get transferred from the IV tube to the sensing device 400. In some embodiments, the static charges 116 accumulated around walls of the IV tube may interfere with functioning of the sensing device 400.

As illustrated in FIG. 5, the sensing device 400 may be installed on the PCB 102. Further, the PCB 102 may be integrated within the infusion pump. In some embodiments, the PCB 102 may comprise one or more layers. Further, the one or more layers may comprise a top layer, bottom layer, and several inner layers. Further, each layer of the one or more layers may serve a distinct purpose (e.g., managing electrical pathways and signal routing). In some embodiments, the top layer of the PCB 102 may be configured to host surface-mount components (e.g., resistors, capacitors, and integrated circuits), copper traces, etc. In some embodiments, the bottom layer of the PCB 102 may comprise various components such as electrical ground planes, or power distribution components. The components of the bottom layer of the PCB 102 facilitate reducing electromagnetic interference (EMI) by providing a common reference point for the one or more signals. In some embodiments, the inner layers may be configured to route complex electrical signals generated by the sensing device 400.

In some embodiments, the PCB 102 may comprise a plurality of plated through holes (PTH) 500. In some embodiments, the plurality of PTH 500 may be configured to establish an electrical connection between the one or more layers of the PCB 102. Further, each of the plurality of PTH 500 may be configured to allow integration of the one or more electronic components 502 with the PCB 102. In some embodiments, each of the plurality of PTH 500 may be configured to carry the one or more signals between the one or more electronic components 502 of the sensing device 400. In some embodiments, the plurality of PTH 500 may be fabricated on the PCB 102 through various processes. The processes may include, but are not limited to, drilling and plating. In some embodiments, the drilling process may involve drilling of a plurality of holes on specific portions the PCB 102. In some embodiments, the drilling process may involve mechanical drills, or laser drills that may drill the plurality of PTH 500 on the PCB 102. In some embodiments, each of the plurality of PTH 500 may be configured to receive a connector terminal(s) of a corresponding electronic component. In some embodiments, the one or more electronic components 502 may be coupled to the PCB 102 through one or more processes. The one or more processes may include, but are not limited to, soldering or adhering.

In some embodiments, the PCB 102 may comprise the sensing device 400 and the one or more electronic components 502 such as capacitors, resistors, and integrated circuits. In some embodiments, the sensing device 400 may be configured to determine the one or more parameters associated with the IV fluid flowing through the IV tube. In some embodiments, the sensing device 400 may be configured to generate the one or more electrical signals corresponding to changes in the one or more parameters. In some embodiments, the PCB 102 may comprise the plurality of PTH 500 that may facilitate integration of the sensing device 400 and the other electronic components 502 over the PCB 102. In some embodiments, the PCB 102 may define a PTH 504, as illustrated in FIG. 5 from the plurality of PTH 500 that may be electrically coupled with the ground plane of the PCB 102.

As illustrated in FIG. 6, the PCB 102 may be encased inside a casing 600. Further, the casing 600 may be configured to be installed within the infusion pump. In some embodiments, the casing 600 may be configured to safeguard the PCB 102 from various hazards such as dust, debris, moisture, mechanical impacts, etc. In some embodiments, the casing 600 of the PCB 102 may be constructed with various materials such as polycarbonate, reinforced fiber, etc. In some embodiments, the casing 600 may be detachably coupled with a cover 602. Further, the cover 602 may be configured to shield the sensing device 400 (not visible in FIG. 6). In some embodiments, the cover 602 may be constructed with a shape such as, but is not limited to, an inverted U-shape, an inverted V-shape, etc. In some embodiments, the cover 602 may be positioned on top of the sensing device 400 (not visible in FIG. 6).

In some embodiments, the conductive polyimide film 302 may be disposed over the sensing device 400. In another embodiment, the conductive membrane 120 may be configured to fully encapsulate the sensing device 400. In some embodiments, the conductive polyimide film 302 (not visible in FIG. 6) may be positioned between the cover 602 and the sensing device 400. In some embodiments, the conductive polyimide film 302 may be configured to discharge the static charges 116 accumulated over the sensing device 400 to the PCB 102. In some embodiments, the conductive polyimide film 302 may comprise at least one Kapton tab 604. In some embodiments, the at least one Kapton tab 604 may extend horizontally from the conductive polyimide film 302. In some embodiments, the at least one Kapton tab 604 of the conductive polyimide film 302 may be inserted within the PTH 504 defined by the PCB 102. In some embodiments, the at least one Kapton tab 604 may be electrically coupled with the ground plane of the PCB 102 through the PTH 504. In various examples, the at least one Kapton tab 604 may be inserted within the PTH 504 through various processes such as soldering, adhering though a conductive epoxy 606, etc. In some embodiments, the conductive polyimide film 302 may be configured to discharge the static charges 116 from the sensing device 400 to the ground plane of the PCB 102 through the at least one Kapton tab 604.

In some embodiments, the cover 602 may comprise an insulating film 800, as illustrated in FIG. 8. Further, the insulating film 800 may be sandwiched between the cover 602 and the conductive polyimide film 302. In some embodiments, the insulating film 800 may be configured to barricade the one or more static charges 116 captured by the conductive polyimide film 302, from the cover 602. As illustrated in FIG. 9, the table 900 may comprise one or more columns and one or more rows. Further, the table 900 may comprise data associated with the one or more properties of the conductive polyimide film 302. Further, the one or more properties may comprise a total thickness (in mils), weight/area (in grams per square meter), amount of metallization (i.e., aluminum metallization) (as a percentage of pure aluminum), surface resistivity (in ohms per square), and operating temperature (in degrees Celsius). In some embodiments, the conductive polyimide film 302 may comprise a total thickness of 0.50 mil, weight/area of 18.0 g/m², amount of metallization (i.e., aluminum metallization) of 99.90 %, surface resistivity of ≤ 0.8 Ω/sq, and an operating temperature of - 250-290 °C.

In some embodiments, a method is disclosed for the sensing device 100. The method comprises one or more operations. At an operation, the conductive port 104 may be coupled to the PCB 102, via the conductive adhesive 108. Further, the conductive port 104 may define the orifice 110 filled with the protective gel 112. In some embodiments, the protective gel 112 that may be filled within the orifice 110 of the conductive port 104 may correspond to at least one of the silicone gel. In some embodiments, the conductive port 104 may correspond to at least one of the metal port or the conductive plastic port. At another operation, the sensing element 106 may be disposed on the PCB 102 within the conductive port 104. Further, the sensing element 106 may be encased by the protective gel 112 inside the orifice 110 of the conductive port 104. At another operation, the conductive member may be disposed at least over the protective gel 112. Further, the conductive member may be configured to discharge the static charges 116 accumulated over the protective gel 112 to the PCB 102 via at least the conductive adhesive 108. In one instance, the conductive member may comprise at least the conductive gel 118, the conductive polyimide film 302, or the conductive membrane 120. In another instance, the conductive member may comprise the conductive gel 118, conductive polyimide film 302, and the conductive membrane 120 altogether.

The present invention may offer enhanced electrostatic discharge (ESD) protection and durability to the sensing device 100 through the conductive member. In the present invention, the use of a conductive gel 118, such as Nickel-Graphite gel, may ensure efficient dissipation of static charges 116 accumulated within the sensing device 100, creating a low-resistance pathway for safe discharge. Additionally, the conductive port 104 of the sensing device 100 may be configured to connect to the conductive gel 118, providing a direct discharge route to the ground plane of the PCB 102. The present invention may include the conductive polyimide film 302 disposed across the orifice 110 of the conductive port 104 offering a robust conductive connection to the conductive port 104 to discharge the static charges 116. Further, the encapsulation of the sensing device 100 by the conductive membrane 120 may provide additional grounding protection, ensuring a reliable connection to the PCB 102.

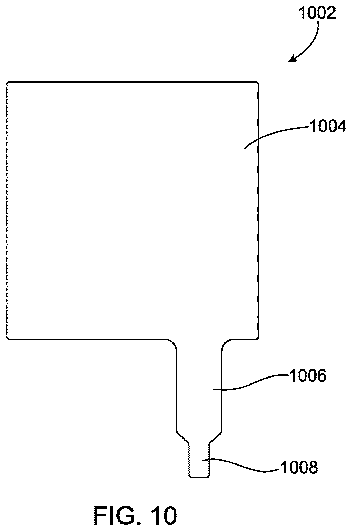

In some embodiments, an alternative conductive membrane may be used in sensor devices of embodiments of the present disclosure, as illustrated in FIGS. 10-12. FIG. 10 illustrates a top view of such an example conductive membrane 1002 which comprises a generally rectangular main body 1004 and a tab extending from an edge of the main body 1004. In various embodiments, the tab comprises a proximal portion 1006 and a distal portion 1008. The distal portion 1008 extends from a distal end of the proximal portion 1006 and is narrower than the proximal portion 1006.

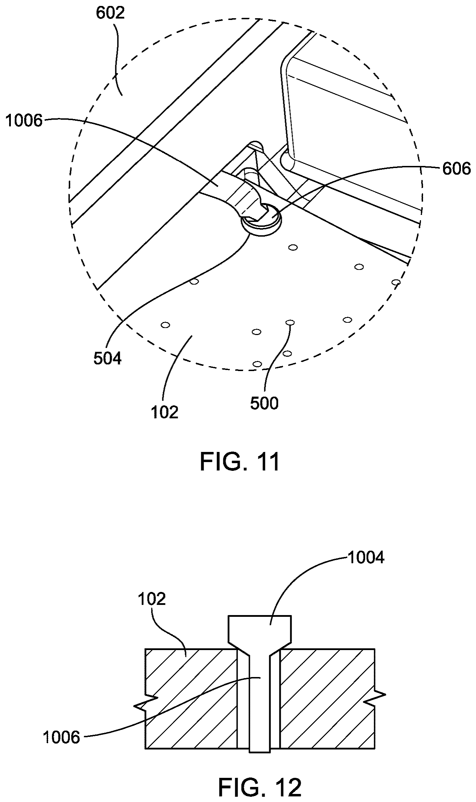

FIG. 11 is similar to the detailed callout of FIG. 6, but FIG. 11 shows how the conductive membrane 1002 is electrically coupled with the ground plane of the PCB 102 through the PTH 504. In the embodiments of FIGS. 10-12, only the distal portion 1008 of the tab of the conductive membrane 1002 is inserted within the PTH 504 through various processes such as soldering, adhering though a conductive epoxy, etc. The greater width of the proximal portion 1006 ensures that only the distal portion 1008 is inserted into the PTH 504, thereby ensuring accurate positioning of the distal portion 1008 and preventing excess strain on the proximal portion 1006. That is, some point along the angled transition between the distal portion 1008 and the proximal portion 1006 contacts the top edge of the PTH 504 to stop the tab from extending further into the PTH 504. This accurate positioning of the distal portion 1008 is seen in FIG. 12 in which the distal portion 1008 extends approximately the full depth of the PTH 504 (generally, having the distal portion 1008 slightly shorter than or slightly longer than the full depth of the PTH 504 is acceptable).

The length of the proximal portion 1006 of the tab is selected to provide a small amount of "slack" when the conductive membrane 1002 is mounted in the sensing device to provide strain relief which helps prevent damage to the conductive membrane 1002 (e.g., tearing at the connection point where the proximal portion 1006 meets the main body 1004).

In various embodiments, the transition points between the main body 1004 and the proximal portion 1006 and the transition points between the proximal portion 1006 and the distal portion 1008 have rounded corners to help prevent damage to the conductive membrane 1002.

Such an alternative conductive membrane as is illustrated in FIGS. 10-12 adds strength to the conductive membrane 1002 to better withstand mechanical forces that may be encountered due to mechanical assembly, handling of the sensor device, and environmental conditions to which the sensor device may be exposed.

Many modifications and other embodiments of the disclosure set forth herein will come to mind to one skilled in the art to which the present disclosure pertains having the benefit of the teachings presented in the foregoing descriptions and the associated drawings. Therefore, it is to be understood that the present disclosure is not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A sensing device comprising:
a printed circuit board (PCB);
a conductive port coupled to the PCB via a conductive adhesive and defining an orifice, wherein the orifice is filled with a protective gel;
a sensing element disposed on the PCB within the conductive port and encased by the protective gel; and
a conductive member disposed at least over the protective gel, wherein the conductive member is configured to discharge static charges accumulated over the protective gel to the PCB via at least the conductive adhesive.

2. The sensing device of claim 1, wherein the conductive member comprises at least a conductive gel disposed in the orifice over the protective gel.

3. The sensing device of claim 2, wherein the conductive gel corresponds to a nickel-graphite silicone gel.

4. The sensing device of claim 1, wherein the conductive member comprises at least a metallic Kapton film disposed over the protective gel and either partially or fully encapsulating the conductive port.

5. The sensing device of claim 4, wherein the metallic Kapton film defines a first side having a non-metallic surface and a second side having a metallic surface; and wherein the non-metallic surface is in contact with the protective gel and the metallic surface is in contact with the conductive port to discharge the static charges from the metallic Kapton film, the conductive port, and the conductive adhesive to the PCB.

6. The sensing device of claim 4, wherein the metallic Kapton film further comprises at least one Kapton tab inserted within a plated through hole (PTH) defined in the PCB such that the static charges discharge directly from the metallic Kapton film to the PCB.

7. The sensing device of claim 1, wherein the conductive member comprises at least a conductive membrane disposed over the protective gel and encapsulating the conductive port coupled with the PCB such that the static charges directly discharge from the conductive membrane to the PCB.

8. A sensing device comprising:
a printed circuit board (PCB);
a port coupled to the PCB via an adhesive and defining an orifice, wherein the orifice is filled with a protective gel;
a sensing element disposed on the PCB within the port and encased by the protective gel; and
a conductive membrane disposed over the protective gel and the port to fully encapsulate the port;
wherein the conductive membrane discharges static charges accumulated over the protective gel to the PCB.

9. The sensing device of claim 8, further comprising a conductive gel disposed in the orifice over the protective gel.

10. A method comprising:
coupling, via a conductive adhesive, a conductive port to a printed circuit board (PCB), wherein the conductive port defines an orifice filled with a protective gel;
disposing a sensing element on the PCB within the conductive port and encased by the protective gel; and
disposing a conductive member at least over the protective gel, wherein the conductive member is configured to discharge static charges accumulated over the protective gel to the PCB via at least the conductive adhesive.

11. The method of claim 10, further comprising disposing at least a metallic Kapton film over the protective gel and either partially or fully encapsulating the conductive port.

12. The method of claim 11, wherein the metallic Kapton film defines a first side having a non-metallic surface and a second side having a metallic surface; and
wherein the non-metallic surface is in contact with the protective gel and the metallic surface is in contact with the conductive port to discharge the static charges from the metallic Kapton film, the conductive port, and the conductive adhesive to the PCB.

13. The method of claim 11 further comprising inserting at least one Kapton tab of the metallic Kapton film within a plated through hole (PTH) defined in the PCB such that the static charges discharge directly from the metallic Kapton film to the PCB.

14. The method of claim 10, wherein the protective gel corresponds to at least one of silicone gel, and the conductive port corresponds to at least one of a metal port or a conductive plastic port.

15. The method of claim 10 further comprising disposing at least a conductive membrane of the conductive member over the protective gel and encapsulating the conductive port coupled with the PCB such that the static charges directly discharge from the conductive membrane to the PCB.
